# EUROPÄISCHE PATENTSCHRIFT

(11) **EP 2 684 273 B1**
(45) Veröffentlichungstag und Bekanntmachung des Hinweises auf die Patenterteilung: **20.04.2016**
(21) Anmeldenummer: 12703493.2
(22) Anmeldetag: 01.02.2012
(51) Int. Cl.: H02H 7/12, H03K 17/60, H03K 17/687, H03K 17/795, H02J 7/00

(54) **STEUERUNG EINER VERSORGUNGSSPANNUNG**
SUPPLY VOLTAGE CONTROL
COMMANDE D'UNE TENSION D'ALIMENTATION

(30) Priorität: 11.03.2011 DE 102011005416
(43) Veröffentlichungstag der Anmeldung: 15.01.2014
(73) Patentinhaber: Robert Bosch GmbH, 70442 Stuttgart (DE)
(72) Erfinder: MACK, Juergen, 73035 Goeppingen (DE)
(86) Internationale Anmeldenummer: PCT/EP2012/051660
(87) Internationale Veröffentlichungsnummer: WO 2012/123177

(56) Entgegenhaltungen:
- WO-A1-01/13492
- US-A1- 2008 303 580
- US-B1- 6 194 871

## Beschreibung

Die Erfindung betrifft eine Schaltung zur Bereitstellung einer Versorgungsspannung. Insbesondere betrifft die Erfindung eine elektronische Schaltung zur Bereitstellung einer Versorgungsspannung zum Aufladen eines elektrischen Energiespeichers.

### Stand der Technik

Zum Aufladen elektrischer Energiespeicher, beispielsweise NiCd- oder NiMH-Akkumulatoren, wird ein Ladegerät verwendet, das an einer Versorgungsspannung betrieben wird und eine Ladespannung an den Energiespeicher bereitstellt, die dessen Aufladung gewährleistet. Zur Absicherung sowohl des Energiespeichers als auch des Ladegeräts gegen außergewöhnliche Betriebszustände wird häufig nur eine sehr einfache Sicherungseinrichtung verwendet, die nach dem so genannten "Crowbar-Prinzip" arbeitet. Hierbei wird bei Auftreten eines außergewöhnlichen Betriebszustands ein Bauelement des Ladegeräts gezielt zerstört, um das Ladegerät abzuschalten und in einen sicheren Betriebszustand zu verbringen. Das zu zerstörende Bauelement kann eine dedizierte Sicherung umfassen. Es kann aber auch ein Bauteil, beispielsweise eine Diode oder ein Transistor, das im Normalbetrieb des Ladegeräts eine weitere Funktion ausfüllt, durch eine überhöhte Spannung oder einen überhöhten Strom gezielt zerstört werden.

Patentdokument WO 01/13492 A1 offenbart eine Abschaltungsvorrichtung wobei eine elektrische Last von einer Versorgungsquelle (z.B. ein Akku) durch eine Halbleiterschaltung getrennt ist.

Dabei ist nachteilig, dass das Ladegerät nach der Zerstörung des Bauteils nicht ohne Weiteres wieder in Betrieb genommen werden kann. Ferner ist es prinzipbedingt nicht möglich, eine Funktion des Abschaltmechanismus beispielsweise im Rahmen einer Qualitätssicherung zu überprüfen. Es besteht somit stets eine gewisse Unsicherheit, ob der Abschaltmechanismus seiner Aufgabe überhaupt nachkommen kann.

Der Erfindung liegt daher die Aufgabe zugrunde, einen zerstörungsfreien Abschaltmechanismus für ein Schaltnetzteil anzugeben.

Die Erfindung löst diese Aufgabe durch eine Schaltung mit den Merkmalen von Anspruch 1. Unteransprüche geben bevorzugte Ausführungsformen wieder.

### Offenbarung der Erfindung

Eine erfindungsgemäße Abschalteinrichtung für ein Schaltnetzteil, wobei das Schaltnetzteil eine Ansteuereinrichtung für einen ersten Transistor zur Erzeugung einer transformierbarenSpannung umfasst, umfasst einen zweiten Transistor vom PNP-Typ und einen dritten Transistor vom NPN-Typ, wobei die Basis des zweiten Transistors mit dem Kollektor des dritten Transistors und die Basis des dritten Transistors mit dem Kollektor des zweiten Transistors verbunden ist. Ferner ist der Emitter des dritten Transistors mit Masse und der Emitter des zweiten Transistors mit einem Steuerspannungsanschluss der Ansteuereinrichtung verbunden, wobei der Steuerspannungsanschluss dazu eingerichtet ist, die Erzeugung der Spannung durch den ersten Transistor zu unterbinden, wenn der Steuerspannungsanschluss an Masse gelegt wird, so dass die Erzeugung der Spannung unterbunden wird, wenn die Basis des dritten Transistors mit einer Spannung beaufschlagt wird, die einen vorbestimmten Schwellenwert übersteigt.

Die beschriebene Abschalteinrichtung aus zwei Transistoren schaltet das Schaltnetzteil über den Steuerspannungsanschluss sicher und effektiv ab, wenn die Basis des dritten Transistors mit einer ausreichend hohen Abschaltspannung verbunden wird. Dabei bleibt der Steuerspannungsanschluss auch dann an Masse geschaltet, wenn die Abschaltspannung wieder absinkt. Erst wenn die an der Abschalteinrichtung anliegende Spannung weit genug abgeklungen ist, etwa weil das Schaltnetzteil abgeschaltet ist, löst sich die Durchsteuerung des Steuerspannungsanschlusses an Masse, so dass das Schaltnetzteil wieder eingeschaltet werden kann. Dadurch wird eine längere Abschaltung für das Schaltnetzteil erzwungen, die eine Sicherheit des Schaltnetzteil und eines mit ihm verbundenen Verbrauchers erhöhen kann. Beispielsweise kann die Abschaltung durch eine detektierte Übertemperatur ausgelöst sein und die Abschaltung kann lange genug dauern, dass das betreffende Element so weit abkühlt, dass ein Betrieb des Schaltnetzteils wieder erfolgen kann.

In einer ersten Ausführungsform umfasst der Steuerspannungsanschluss einen Steueranschluss des ersten Transistors. Dadurch kann die Abschaltung bei jeder Art primär getaktetem Schaltnetzteil erfolgen, insbesondere solchen, die als Selbstschwinger aufgebaut sind.

In einer zweiten Ausführungsform umfasst der Steuerspannungsanschluss einen Steueranschluss einer Spannungsquelle zur Bereitstellung einer Betriebsspannung für die Ansteuereinrichtung für den ersten Transistor. Dadurch kann eine Funktion der Ansteuereinrichtung ausgenutzt werden, die bei einer Unterspannung die Ansteuerung des ersten Transistors einstellt. Dadurch kann die Abschalteinrichtung auch an einem Schaltnetzteil eingesetzt werden, das einen integrierten Schaltkreis als Ansteuereinrichtung verwendet, der keinen dedizierten Eingang zur Abschaltung aufweist und der in einer Ausführungsform auch den ersten Transistor umfasst.

Zwischen dem Emitter und der Basis des PNP-Transistors kann ein erster Kondensator verbunden sein und/oder zwischen der Basis und dem Emitter des NPN-Transistors kann ein zweiter Kondensator verbunden sein. Dadurch kann die Abschalteinrichtung jeweils resistenter gegen Störimpulse sein.

Zwischen dem Emitter des zweiten Transistors und dem Emitter des dritten Transistors kann ein Speicherkondensator vorgesehen sein. Dadurch kann eine Abschaltzeit verlängert sein, so dass eine Abschaltung des Schaltnetzteils wenigstens eine vorbestimmte Zeit dauert.

In einer Ausführungsform ist ein Optokoppler vorgesehen, um ein Potential des Abschaltimpulses von der Abschalteinrichtung zu trennen. Dadurch kann eine Betriebssicherheit, beispielsweise in einem netzbetriebenen Ladegerät, sichergestellt sein.

Die Erfindung wird nun mit Bezug auf die beigefügten Figuren genauer beschrieben, in denen:
- Figur 1: ein Blockschaltbild eines Geräts mit einem Schaltnetzteil;
- Figur 2: eine Schaltung im Gerät aus Figur 1;
- Figur 3: eine Variation der Schaltung von Figur 2;
- Figur 4: eine weitere Ausführungsform einer Schaltung im Gerät aus Figur 1; und
- Figur 5: eine Variation der Schaltung von Figur 4 darstellt.

### Genaue Beschreibung von Ausführungsformen

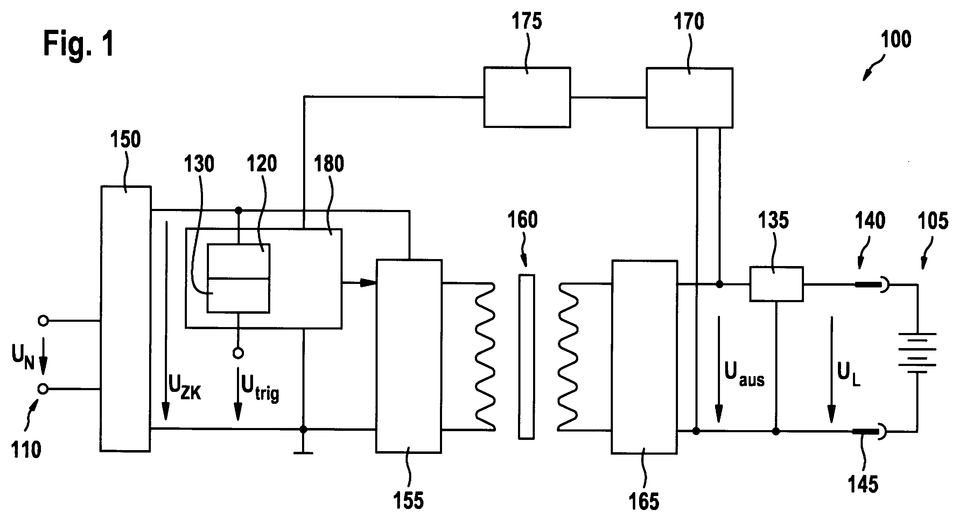

Figur 1 zeigt ein schematisches Blockschaltbild eines Geräts 100 und eines mit dem Gerät 100 verbindbaren Energiespeichers 105. Der Energiespeicher 105 ist ein Akkumulator, beispielsweise auf Lithium-Ionen- oder Nickel-Metallhydrid-Basis. Das Gerät 100 ist ein Ladegerät für den Energiespeicher 105.

Das Gerät 100 umfasst einen Netzanschluss 110, einen Gleichrichter 150, eine Schalteinrichtung 155, einen Transformator 160, einen weiteren Gleichrichter 165, einen Regelverstärker 170, einen Optokoppler 175 und eine Steuerung 180 mit einer Abschalteinrichtung 130.

Der Netzanschluss 110 dient zur Verbindung mit einer Netzspannung U_{N} eines Energieversorgungsnetzes, insbesondere eines Wechselspannungsnetzes mit 110V/60Hz oder 230V/50Hz. Der Netzanschluss 110 ist mit dem Gleichrichter 150 verbunden. Der Gleichrichter 150 filtert und richtet die Netzspannung U_{N} gleich und stellt auf deren Basis die Zwischenkreisspannung U_{ZK} bereit, die eine Gleichspannung ist.

Die Zwischenkreisspannung U_{ZK} speist die Steuerung 180 mit der Abschalteinrichtung 130 sowie die Schalteinrichtung 155. Die Schalteinrichtung 155 wandelt die Zwischenkreisspannung U_{ZK} in eine durch den Transformator 160 transformierbare Spannung um und stellt die umgewandelte Spannung dem Transformator 160 bereit. Die bereitgestellte Spannung kann eine Rechteck-, Stufen-, Trapez-, Sinus- oder andere durch den Transformator 160 verarbeitbare Form aufweisen. Dabei wird üblicherweise eine Frequenz verwendet, die über der Frequenz der Netzspannung U_{N} liegt, beispielsweise 50 kHz bis 200 kHz, insbesondere 100 kHz. Der Transformator 160 transformiert die umgewandelte Spannung, die der Gleichrichter 165 in die Ausgangsspannung Uₐᵤₛ umwandelt, die dem Laderegler 135 bereitgestellt wird.

Ein Ausgang des Ladereglers 135 ist an einem ersten Ladeanschluss 140 des Ladegeräts 100 herausgeführt; ein zweiter Ladeanschluss 145 ist direkt mit dem Gleichrichter 165 verbunden. Der Energiespeicher 105 ist mittels korrespondierender Ladeanschlüsse 140, 145 mit dem Ladegerät 100 verbindbar, um am Ladegerät 100 aufgeladen zu werden. In einer bevorzugten Ausführungsform weist der Laderegler 135 eine Abschaltfunktion bei Unterspannung auf. Sinkt die Ausgangsspannung Uₐᵤₛ unter einen vorbestimmten Wert, so stellt der Laderegler 135 das Laden des Energiespeichers 105 ein. In einer Ausführungsform wird der Energiespeicher 105 an einer konstanten Spannung geladen. Dabei kann der Laderegler 135 entfallen und die Ladespannung U_{L} wird durch die Ausgangsspannung Uₐᵤₛ bereitgestellt. In weiteren Ausführungsformen können mehrere der Elemente 120 bis 135 miteinander in einem Bauteil integriert sein.

Die Ausgangsspannung Uₐᵤₛ wird durch den Regelverstärker 170 überwacht, der in Abhängigkeit der Ausgangsspannung Uₐᵤₛ ein Signal bereitstellt, das mittels des Optokopplers 175 der Steuerung 180 bereitgestellt wird. Die Steuerung 180 generiert auf der Basis des bereitgestellten Signals ein Steuersignal für die Schalteinrichtung 155, um die durch den Gleichrichter 165 generierte Gleichspannungauf eine vorbestimmte Spannung bzw. den durch den Gleichrichter 165 bereitgestellten Strom auf einen vorbestimmten Strom zu regeln.

Die Abschalteinrichtung 130 ist dazu eingerichtet, mittels einer Abschaltspannung U_{trig} ausgelöst zu werden. Ist die Abschalteinrichtung 130 ausgelöst, so greift sie derart in die Funktion der Steuerung 180 ein, dass die Schalteinrichtung 155 nicht mehr durchschalten kann, so dass die Energieübertragung über den Transformator 160 zum erliegen kommt und die Ausgangsspannung Uₐᵤₛ abgeschaltet ist. Die Abschaltspannung U_{trig} kann auf der Basis beispielsweise einer Überspannung, einer Unterspannung, einem Überstrom, einem Unterstrom, einer Übertemperatur und/oder einer Untertemperatur eines beliebigen Elements am Ladegerät 100 bereitgestellt sein.

In einer Ausführungsform kann die Steuerung 180 unmittelbar eine Steuerspannung, die der Schalteinrichtung 155 durch die Steuerung 180 bereitgestellt wird, nach Masse ableiten. In einer anderen Ausführungsform umfasst die Steuerung 180 eine Spannungsquelle 120 zur Bereitstellung einer Betriebsspannung für die Steuerung 180 und die Abschalteinrichtung 130 beeinflusst die Spannungsquelle 120 derart, dass die bereitgestellte Betriebsspannung so weit absinkt, dass ein Unterspannungsschutz der Steuerung 180 aktiviert wird, der die Steuerspannung, die der Schalteinrichtung 155 bereitgestellt wird, abschaltet. Dabei kann ein Teil der Steuerung 180 in Form eines Integrierten Schaltkreises (IC) vorliegen, der mit der Schalteinrichtung 155 integriert ausgeführt sein kann. In diesem Fall ist die Spannungsquelle 120 für die Betriebsspannung der integrierten Steuerung 180 nicht mit integriert und kann durch die Abschalteinrichtung 130 beeinflusst werden.

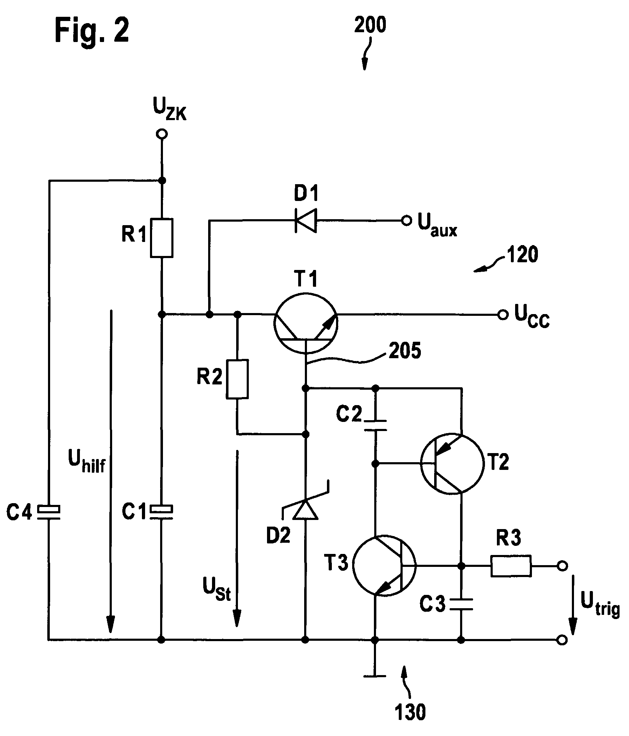

Figur 2 zeigt eine Schaltung 200 im Ladegerät 100 aus Figur 1. Die Schaltung 200 repräsentiert die Spannungsquelle 120 und die Abschalteinrichtung 130 in der Steuerung 180 in Figur 1. Die in Figur 2 dargestellte Ausführungsform der Abschalteinrichtung 130 eignet sich besonders dann, wenn die Ansteuerung der Schalteinrichtung 155 mittels einer als integrierter Schaltkreis ausgeführten Steuerung 180 durchgeführt wird. Um das Schaltnetzteil 100 abzuschalten, wird die Spannungsquelle 120 abgeschaltet, so dass die restliche Steuerung 180 eine Unterspannung detektiert und die Ansteuerung der Schalteinrichtung 155 einstellt.

Die Spannungsquelle 120 in Figur 2 ist im Wesentlichen durch einen NPN-Transistor T1, eine Zenerdiode D2 und einen Widerstand R2 gebildet. Die Abschalteinrichtung 130 ist aufgebaut aus Transistoren T2 und T3, Kondensatoren C2 und C3 sowie einem Widerstand R3.

Die Zwischenkreisspannung U_{ZK} ist über einen Widerstand R1 als Hilfsspannung U_{hilf} mit dem Kollektor des NPN-Transistors T1 verbunden. Vom Kollektor des NPN-Transistors T1 aus führt ein Kondensator C1, vorzugsweise ein Elektrolytkondensator mit hoher Speicherfähigkeit, an Masse.

Der Emitter des NPN-Transistors T1 stellt die Versorgungsspannung Ucc bereit. Das Bereitstellen erfolgt in Abhängigkeit einer Steuerspannung U_{St}, die an der Basis des NPN-Transistors T1, hier als Steuerspannungsanschluss 205 bezeichnet, anliegt. Um eine geeignete Steuerspannung U_{St} zu erzeugen, ist der Widerstand R2 in Serie mit einer Zenerdiode D2 vom Kollektor des NPN-Transistors T1 an Masse geschaltet. Über der Zenerdiode D2 fällt eine vorbestimmte Spannung ab, so lange die Hilfsspannung U_{hilf} über der Serienschaltung aus dem Widerstand R2 und der Zenerdiode D2 die vorbestimmte Spannung übersteigt. Die Basis des NPN-Transistors T1 bzw. der Steuerspannungsanschluss 205 ist zwischen dem Widerstand R2 und der Zenerdiode D2 verbunden.

Der NPN-Transistor T1 wird üblicherweise mittels der Steuerspannung Uₛₜ in Sättigung betrieben, d. h., dass keine Begrenzung bzw. Regelung der Versorgungsspannung Ucc stattfindet. Verlässt der NPN-Transistor T1 diesen Arbeitspunkt, so wird eine Verlustleistung innerhalb des NPN-Transistors T1 in Wärme umgesetzt. Mittels der Diode D1 wird eine Zusatzspannung Uₐᵤₓ an den Kollektor des Transistors T1 eingekoppelt. Der Betrag der Zusatzspannung Uₐᵤₓ wird üblicherweise empirisch ermittelt und sicherheitshalber um einen vorbestimmten Betrag von einigen Volt oberhalb der empirisch ermittelten Spannung gewählt. Durch geeignete Wahl der Zenerdiode D2 kann ein Arbeitspunkt des NPN-Transistors T1 bezüglich eines Begrenzungsverhaltens beeinflusst werden. Dieser Arbeitspunkt kann durch die Schaltung um die Transistoren T2 und T3 verschoben werden, so dass der NPN-Transistor T1 verstärkt begrenzt, nachdem die Auslösespannung U_{trig} über den vorbestimmten Schwellenwert angestiegen ist.

Die Bauteile der Abschalteinrichtung 130 sind zwischen der Basis des NPN-Transistors T1 und Masse geschaltet. Transistor T2 ist ein PNP-Transistor, während Transistor T3 ein NPN-Transistor ist. Die Basis des Transistors T2 ist mit dem Kollektor des Transistors T3 und die Basis des Transistors T3 mit dem Kollektor des Transistors T2 verbunden. Der Emitter des Transistors T2 führt zur Basis des NPN-Transistors T1, der Emitter des Transistors T3 ist mit Masse verbunden. Die Kondensatoren C2 und C3 sind zwischen der Basis und dem Emitter des Transistors T2 bzw. des Transistors T3 angeordnet. Die Abschaltspannung U_{trig} wird mittels des Widerstands R3 an die Basis des Transistors T3 bzw. den Kollektor des Transistors T2 eingekoppelt, wobei der Widerstand R3 dazu dient, den Strom durch die Basis-Emitter-Strecke des Transistors T3 zu begrenzen.

Im Normalbetrieb der Schaltung 200 sperren beide Transistoren T2 und T3. Übersteigt die Abschaltspannung U_{trig} einen vorbestimmten Wert, so schaltet der Transistor T3 durch und seine Kollektor-Emitter-Strecke wird leitend. Dadurch wird die Basis des Transistors T2 gegen Masse gezogen, so dass der Transistor T2 ebenfalls durchschaltet und seine Emitter-Kollektor-Strecke leitend wird. Dadurch wird die Steuerspannung Uₛₜ, die am Emitter des Transistors T2 anliegt, an den Kollektor des Transistors T2 und damit an die Basis des Transistors T3 durchgeleitet, so dass der Transistor T3 im leitenden Zustand verbleibt, unabhängig davon, ob die Abschaltspannung U_{trig} wieder unter den vorbestimmten Wert absinkt oder nicht.

Während die Transistoren T2 und T3 leiten, fließt ein Strom parallel zur Zenerdiode D2, so dass die Spannungsquelle 120 derart verstimmt ist, dass die Steuerspannung Uₛₜ absinkt. Dadurch sperrt der NPN-Transistors T1 und die Versorgungsspannung Ucc bricht auf nahezu 0 zusammen.

Die Kondensatoren C2 und C3 der Abschalteinrichtung 130 stellen sicher, dass beim Einschalten der Schaltung 200, wenn also die Zwischenkreisspannung U_{ZK} und die Zusatzspannung Uₐᵤₓ von 0 ansteigen, die beiden Transistoren T2 und T3 zunächst im nicht leitenden Zustand bleiben, falls die Abschaltspannung U_{trig} zu diesem Zeitpunkt unterhalb des vorbestimmten Werts liegt.

Um die Transistoren T2 und T3 der ausgelösten Abschalteinrichtung 130 wieder in einen nicht leitenden Zustand zu bringen, ist es erforderlich, die Steuerspannung U_{St}, aus der die beiden Transistoren T2 und T3 gespeist werden, bis auf 0 abzusenken. Zu diesem Zweck wird üblicherweise die Zwischenkreisspannung U_{ZK} unterbrochen, beispielsweise, indem das Ladegerät 100 am Netzanschluss 110 vom Versorgungsnetzwerk getrennt wird, oder indem ein Hauptschalter des Geräts 100 die Bereitstellung der Zwischenkreisspannung U_{ZK} verhindert. Die Transistoren T2 und T3 bleiben noch so lange im leitenden Zustand, bis der Kondensator C1, der parallel zur Hilfsspannung U_{hilf} geschaltet ist, und der Kondensator C4, der parallel zur Zwischenkreisspannung U_{ZK} geschaltet ist, entladen sind. Der Entladevorgang des Kondensators C4 kann einige Sekunden bis hin zu mehreren Minuten dauern. Wird während der Entladezeit die Zwischenkreisspannung U_{ZK} wieder bereitgestellt, bleiben die Transistoren T2 und T3 im leitenden Zustand und die Versorgungsspannung Ucc bleibt abgeschaltet.

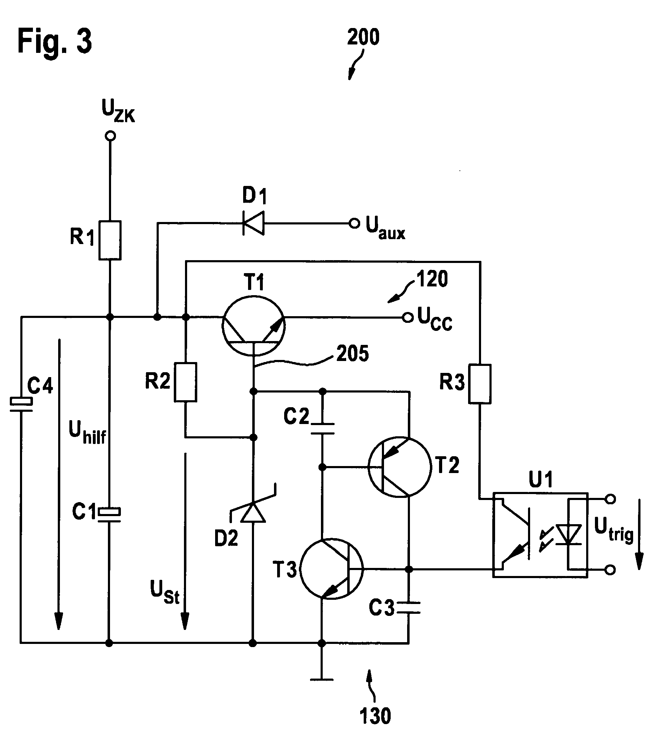

Figur 3 zeigt eine Variation der Schaltung 200 aus Figur 1. Hier ist die Abschaltspannung U_{trig} mittels eines Optokopplers U1 von den Transistoren T2 und T3 entkoppelt. Der Optokoppler U1 umfasst eine Leuchtdiode, die mittels der Abschaltspannung U_{trig} angesteuert werden kann. Die Leuchtdiode wirkt auf einen Phototransistor des Optokopplers U1, bis der Phototransistor durchsteuert und eine leitende Verbindung auf seiner Kollektor-Emitter-Strecke besteht. Der Emitter und der Kollektor des Phototransistors sind am Optokoppler U1 herausgeführt, wobei der Emitter mit der Basis des Transistors T3 und der Kollektor über den Widerstand R3 mit der Hilfsspannung U_{hilf} am Kollektor des NPN-Transistors T1 verbunden ist. Leuchtet die Leuchtdiode im Optokoppler U1, so wird die Basis des NPN-Transistors T3 auf ein Potential gelegt, das aus U_{hilf} abgeleitet ist und den Transistor T3 durchsteuert. Die restliche Funktion der Transistoren T2 und T3 ist oben mit Bezug auf Figur 2 beschrieben. Durch Einsatz des Optokopplers U1 ist die Abschaltspannung U_{trig} galvanisch vom Rest der Schaltung 200 getrennt.

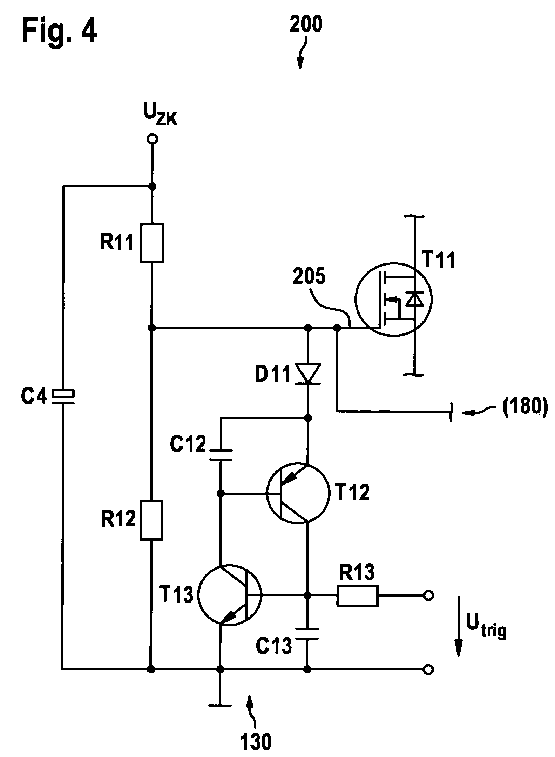

Figur 4 zeigt eine weitere Ausführungsform einer Schaltung 200 im Gerät aus Figur 1. Die Schaltung 200 repräsentiert die Abschalteinrichtung 130 in der Steuerung 180 in Figur 1; ferner sind ein Anschluss zu einem nicht dargestellten Teil der Steuerung 180 und ein FET-Transistor T11 dargestellt, der die Schalteinrichtung 155 in Fig. 1 repräsentiert. Ein Gate-Anschluss des FET-Transistors T11 bildet hier den Steuerspannungsanschluss 205. Der FET-Transistor T11 kann ein Leistungstransistor sein, durch den ein großer Anteil einer durch das Schaltnetzteil 100 bereitgestellten elektrischen Leistung fließt. Insbesondere kann der FET-Transistor T11 ein MOSFET sein. In einer anderen Ausführungsform kann auch an Stelle des FET-Transistors T11 ein Thyristor oder ein anderes elektronisches Schaltelement verwendet werden.

Die in Figur 4 dargestellte Ausführungsform der Abschalteinrichtung 130 kann zur Abschaltung des FET-Transistors T11 verwendet werden und ist dann zu bevorzugen, wenn eine andere Einflussmöglichkeit auf die Steuerung 180 nicht gegeben ist. Um das Schaltnetzteil 100 abzuschalten, wird die der Steueranschluss des FET-Transistors T11 an Masse gelegt, so dass dem Transformator 160 keine Spannung mehr bereitgestellt wird und die Energieübertragung durch den Transformator 160 zum erliegen kommt.

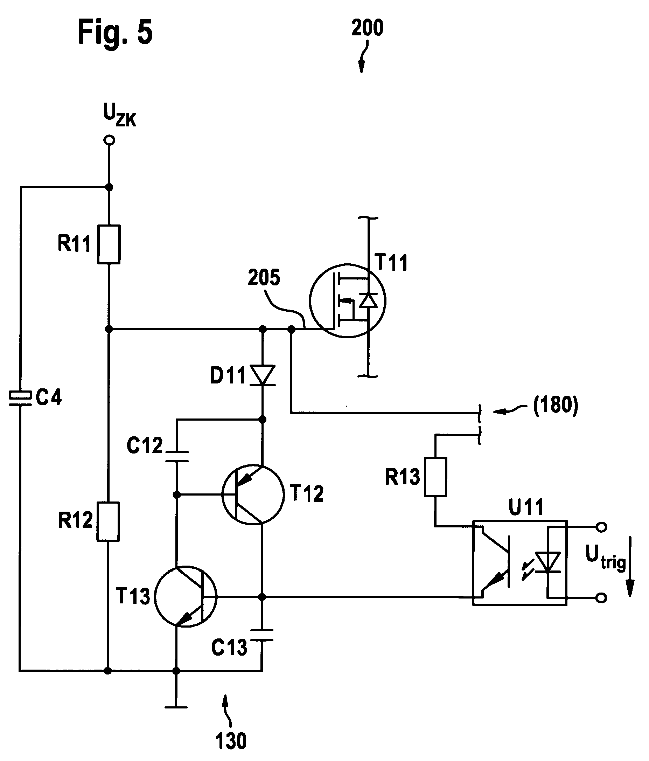

Die restlichen dargestellten Bauteile entsprechen im Wesentlichen den in der Ausführungsform von Figur 5 verwendeten Bauteilen, wurden der Klarheit halber jedoch mit einer vorangestellten 1 gekennzeichnet. Insbesondere entspricht die dargestellte Abschalteinrichtung 130, bestehend aus den Transistoren T12 und T13 sowie den Kondensatoren C12 und C13 und dem Widerstand R13, der Abschalteinrichtung 130 in Figur 2 aus den Transistoren T2, T3 sowie den Kondensatoren C2, C3 und dem Widerstand R3.

Die Steuerspannung am Steuerspannungsanschluss 205 wird durch einen Spannungsteiler mittels der Widerstände R11 und R12 aus der Zwischenkreisspannung U_{ZK} bereitgestellt. Der Emitter des PNP-Transistors T12 ist mittels der Diode D11 mit dem Steuerspannungsanschluss 205 des FET-Transistors T11 verbunden. Ein Kondensator analog zu C1 aus Figur 2 ist in der dargestellten Ausführungsform nicht vorgesehen.

In entsprechender Weise wie oben bezüglich der Ausführungsform von Figur 2 beschrieben ist, wird die Steuerspannung am Steuerspannungseingang 205 des FET-Transistors T11 durch die Abschalteinrichtung 130 abgesenkt, falls die Abschaltspannung U_{trig} einen vorbestimmten Wert übersteigt. Dadurch wird der FET-Transistor T11 im Wesentlichen abgeschaltet, so dass dem Transformator 160 keine Spannung mehr bereitgestellt wird und die Energieübertragung durch den Transformator 160 zum erliegen kommt.Die Absenkung bleibt aufrecht erhalten, auch wenn die Abschaltspannung U_{trig} unter den vorbestimmten Wert absinkt. Um die Absenkung aufzuheben, muss zunächst die Zwischenkreisspannung U_{ZK} unterbrochen werden.

Figur 5 zeigt eine Variation der Schaltung 200 von Figur 4. In entsprechender Weise wie oben mit Bezug auf Figur 3 erläutert wurde, ist ein Optokoppler U11 vorgesehen, der dem Optokoppler U1 entspricht, um die Abschaltspannung U_{trig} von den restlichen Elementen der Schaltung 200 galvanisch zu trennen.

## Patentansprüche

1. Abschalteinrichtung (200) für ein Schaltnetzteil, wobei das Schaltnetzteil eine Ansteuereinrichtung (180) für einen ersten Transistor (T1) zur Erzeugung einer transformierbaren Spannung umfasst, und:
- die Abschalteinrichtung einen zweiten (T2, T12) Transistor vom PNP-Typ und einen dritten Transistor (T3, T13) vom NPN-Typ umfasst;
- die Basis des zweiten Transistors (T2, T12) mit dem Kollektor des dritten Transistors (T3, T13) verbunden ist;
- die Basis des dritten Transistors (T3, T13) mit dem Kollektor des zweiten Transistors (T2, T12) verbunden ist;
- der Emitter des dritten Transistors (T3, T13) mit Masse verbunden ist, und
- der Emitter des zweiten Transistors (T2, T12) mit einem Steuerspannungsanschluss (205) der Ansteuereinrichtung (180) verbunden ist, wobei der Steuerspannungsanschluss (205) dazu eingerichtet ist, die Erzeugung der Spannung durch den ersten Transistor (T1) zu unterbinden, wenn der Steuerspannungsanschluss (205) an Masse gelegt wird,
- so dass die Erzeugung der Spannung unterbunden wird, wenn die Basis des dritten Transistors (T3, T13) mit einer Spannung beaufschlagt wird, die einen vorbestimmten Schwellenwert übersteigt.

2. Abschalteinrichtung (200) nach Anspruch 1, wobei der Steuerspannungsanschluss (205) einen Steueranschluss des ersten Transistors (T1) umfasst.

3. Abschalteinrichtung (200) nach Anspruch 1, wobei der Steuerspannungsanschluss (205) einen Steueranschluss einer Spannungsquelle (120) zur Bereitstellung einer Betriebsspannung für die Ansteuereinrichtung (180) für den ersten Transistor (T1) umfasst.

4. Abschalteinrichtung (200) nach einem der vorangehenden Ansprüche, **dadurch gekennzeichnet, dass** ein erster Kondensator (C2) zwischen dem Emitter und der Basis des PNP-Transistors (T2, T12) verbunden ist.

5. Abschalteinrichtung (200) nach einem der vorangehenden Ansprüche, **dadurch gekennzeichnet, dass** ein zweiter Kondensator (C3) zwischen der Basis und dem Emitter des NPN-Transistors (T3, T13) verbunden ist.

6. Abschalteinrichtung (200) nach einem der vorangehenden Ansprüche, wobei ein Speicherkondensator (C1, C4) zwischen dem Emitter des zweiten Transistors (T2, T12) und dem Emitter des dritten Transistors (T3, T13) vorgesehen ist,

7. Abschalteinrichtung (200) nach einem der vorangehenden Ansprüche, wobei ein Optokoppler (U1, U11) vorgesehen ist, um ein Potential der Abschaltspannung (U_{trig}) von der Abschalteinrichtung (130) zu trennen.

## Claims

1. Turn-off device (200) for a switched-mode power supply, wherein the switched-mode power supply comprises a drive device (180) for a first transistor (T1) for generating a transformable voltage, and:
- the turn-off device comprises a second (T2, T12) transistor of the PNP type and a third transistor (T3, T13) of the NPN type;
- the base of the second transistor (T2, T12) is connected to the collector of the third transistor (T3, T13) ;
- the base of the third transistor (T3, T13) is connected to the collector of the second transistor (T2, T12);
- the emitter of the third transistor (T3, T13) is connected to earth, and
- the emitter of the second transistor (T2, T12) is connected to a control voltage terminal (205) of the drive device (180), wherein the control voltage terminal (205) is designed to prevent the generation of the voltage by means of the first transistor (T1) if the control voltage terminal (205) is connected to earth,
- such that the generation of the voltage is prevented if a voltage which exceeds a predetermined threshold value is applied to the base of the third transistor (T3, T13).

2. Turn-off device (200) according to Claim 1, wherein the control voltage terminal (205) comprises a control terminal of the first transistor (T1).

3. Turn-off device (200) according to Claim 1, wherein the control voltage terminal (205) comprises a control terminal of a voltage source (120) for providing an operating voltage for the drive device (180) for the first transistor (T1).

4. Turn-off device (200) according to any of the preceding claims, **characterized in that** a first capacitor (C2) is connected between the emitter and the base of the PNP transistor (T2, T12).

5. Turn-off device (200) according to any of the preceding claims, **characterized in that** a second capacitor (C3) is connected between the base and the emitter of the NPN transistor (T3, T13).

6. Turn-off device (200) according to any of the preceding claims, wherein a storage capacitor (C1, C4) is provided between the emitter of the second transistor (T2, T12) and the emitter of the third transistor (T3, T13).

7. Turn-off device (200) according to any of the preceding claims, wherein an optocoupler (U1, U11) is provided in order to disconnect, a potential of the turn-off voltage (U_{trig}) from the turn-off device (130).

## Revendications

1. Dispositif de coupure (200) pour un bloc d'alimentation à découpage, dans lequel le bloc d'alimentation à découpage comprend un dispositif de commande (180) pour un premier transistor (T1) destiné à générer une tension transformable ; et
- le dispositif de coupure comprend un deuxième transistor (T2, T12) de type PNP et un troisième transistor (T3, T13) du type NPN ;
- la base du deuxième transistor (T2, T12) est connectée au collecteur du troisième transistor (T3, T13) ;
- la base du troisième transistor (T3, T13) est connectée au collecteur du deuxième transistor (T2, T12) ;
- l'émetteur du troisième transistor (T3, T13) est connecté à la masse ; et
- l'émetteur du deuxième transistor (T2, T12) est connecté à une borne de tension de commande (205) du dispositif de commande (180), dans lequel la borne de tension de commande (205) est conçue pour arrêter la génération de la tension par le premier transistor (T1) lorsque la borne de tension de commande (205) est mise à la masse,
- de sorte que la génération de la tension est arrêtée lorsque la base du troisième transistor (T3, T13) est soumise à une tension qui est supérieure à une valeur de seuil prédéterminée.

2. Dispositif de coupure (200) selon la revendication 1, dans lequel la borne de tension de commande (205) comprend une borne de commande du premier transistor (T1).

3. Dispositif de coupure (200) selon la revendication 1, dans lequel la borne de tension de commande (205) comprend une borne de commande d'une source de tension (120) destinée à fournir une tension de fonctionnement pour le dispositif de commande (180) et pour le premier transistor (T1).

4. Dispositif de coupure (200) selon l'une quelconque des revendications précédentes, **caractérisé en ce qu'**un premier condensateur (C2) est connecté entre l'émetteur et la base du transistor PNP (T2, T12).

5. Dispositif de coupure (200) selon l'une quelconque des revendications précédentes, **caractérisé en ce qu'**un deuxième condensateur (C3) est connecté entre la base et l'émetteur du transistor PNP (T3, T13).

6. Dispositif de coupure (200) selon l'une quelconque des revendications précédentes, dans lequel un condensateur de stockage (C1, C4) est prévu entre l'émetteur du deuxième transistor (T2, T12) et l'émetteur du troisième transistor (T3, T13).

7. Dispositif de coupure (200) selon l'une quelconque des revendications précédentes, dans lequel il est prévu un coupleur optique (U1, U11) destiné à séparer un potentiel de la tension de coupure (Utrig) du dispositif de coupure (130).
